# EUROPÄISCHE PATENTSCHRIFT

(11) **EP 2 865 027 B1**
(45) Veröffentlichungstag und Bekanntmachung des Hinweises auf die Patenterteilung: **19.12.2018**
(21) Anmeldenummer: 13782665.7
(22) Anmeldetag: 14.10.2013
(51) Int. Cl.: H01L 41/047, H01L 41/273, H01L 41/293, H01L 41/297

(54) **VERFAHREN ZUM HERSTELLEN EINES ELEKTRONISCHEN BAUELEMENTS ALS STAPEL**
METHOD FOR PRODUCING AN ELECTRONIC STRUCTURAL ELEMENT AS A STACK
PROCÉDÉ DE FABRICATION D'UN COMPOSANT ÉLECTRONIQUE SOUS LA FORME D'UN EMPILAGE

(30) Priorität: 15.10.2012 DE 102012218755
(43) Veröffentlichungstag der Anmeldung: 29.04.2015
(73) Patentinhaber: Continental Automotive GmbH, 30165 Hannover (DE)
(72) Erfinder: RICHTER, Thomas, 93051 Regensburg (DE); ZUMSTRULL, Claus, 93128 Regenstauf (DE)
(86) Internationale Anmeldenummer: PCT/EP2013/071375
(87) Internationale Veröffentlichungsnummer: WO 2014/060327

(56) Entgegenhaltungen:
- EP-A1- 0 113 999
- EP-A2- 1 107 325
- DE-A1- 19 913 271
- DE-A1-102010 063 205
- US-A1- 2006 067 029

## Beschreibung

Die Erfindung betrifft Verfahren zum Herstellen eines elektronischen Bauelements als Stapel und ein als Stapel hergestelltes Bauelement. Ein solches Bauelement wird z.B. als Aktuatoreinheit zum Einspritzen von Kraftstoffen in einen Brennraum eines Zylinders einer Verbrennungskraftmaschine verwendet.

Eine Aktuatoreinheit für ein Einspritzventil einer Verbrennungskraftmaschine eines Fahrzeugs umfasst typischerweise ein als Stapel ausgebildetes Bauelement, das eine Mehrzahl von Elektrodenschichten sowie eine Mehrzahl von auf Anlegen eines elektrischen Feldes reagierenden Werkstoffschichten aufweist, wobei jede Werkstoffschicht zwischen zwei der Elektrodenschichten angeordnet ist. Ein solches Bauelement von übereinander und alternierend zueinander gestapelten Schichten von Werkstoffschicht und Elektrodenschicht wird allgemein als Stapel bezeichnet. Das heutzutage bekannteste elektronische Bauelement dieser Art ist allgemein als ein Piezoaktor bezeichneter Stapel, der als Betätigungselement in Einspritzventilen der verschiedensten Motortypen für Kraftfahrzeuge zur Anwendung kommt. Die Werkstoffschichten sind bei diesem Piezoaktor Keramikschichten.

Üblicherweise weist ein solcher Stapel, in der Draufsicht betrachtet, einen rechteckigen oder quadratischen Querschnitt auf. Der Stapel wird typischerweise an zwei sich gegenüberliegenden Umfangsseiten elektrisch kontaktiert. Um dies technologisch sorgfältig durchführen zu können, werden die Elektrodenschichten geometrisch z.B. so ausgelegt, dass sich nur jede zweite Elektrodenschicht seitlich bis zu einer der beiden Umfangsseiten erstreckt, während sich die jeweils anderen Elektrodenschichten nicht bis zu dieser einen Umfangsseite hin erstrecken. Entsprechendes gilt für die andere Umfangsseite des Stapels analog. Darüber hinaus sind sog. vollaktive Stapel bekannt, bei denen die Elektrodenschichten und die Werkstoffschichten die gleiche Fläche aufweisen, wodurch sich sämtliche Elektrodenschichten jeweils bis an die gegenüberliegenden Umfangsseiten erstrecken.

Die elektrische Kontaktierung der Elektrodenschichten erfolgt in beiden Fällen über zwei Außenelektroden, welche allgemein an zumindest einer Umfangsseite des Bauelements und typischerweise an zwei sich gegenüberliegenden Umfangsseiten mit jeweiligen Elektrodenschichten elektrisch verbunden sind. Die Art der Kontaktierung hängt dabei davon ab, ob es sich um einen vollaktiven Stapel handelt oder nicht.

Bei einem vollaktiven Stapel wird zur Erzeugung der Außenelektroden auf die jeweiligen Umfangsseiten eine Passivierung aufgebracht. Anschließend wird jede zweite Elektrode mittels subtraktiver Verfahren durch die Erzeugung von Gräben oder Ausnehmungen in der Passivierung freigelegt. Hierauf wird ein elektrisch leitfähiges Material, wie z.B. ein Leiterkleber auf die Passivierung aufgebracht, welcher in die Gräben oder Ausnehmungen eindringt und einen elektrischen Kontakt zu den Elektrodenschichten herstellt. Dieses Vorgehen ist mit einigen Nachteilen verbunden.

Für die Passivierung ist ein Material nötig, welches sich nachträglich gezielt abtragen lässt und temperaturbeständig bis 190°C ist. Diese Anforderungen erfordern die Materialgruppe der Polyimide, welche jedoch gesundheitsschädliche Lösungsmittel beinhalten. Diese Lösungsmittel erfordern daher während der Fertigung Maßnahmen zum Schutz der Gesundheit von Mitarbeitern, was die Prozesse aufwendiger gestaltet. Gleiches gilt für den Leitkleber, mit welchem nach dem Freilegen der Elektroden die Weiterkontaktierung erfolgt.

Das fertig gestellte Bauelement ist von einer Rohrfeder umgeben, welche typischerweise aus einem Metall besteht. Die Rohrfeder dient dazu, im Betrieb der Aktuatoreinheit den Bauelementstapel. Ferner dient die Rohrfeder dazu, eine ausreichende Performance für den ausgelenkten Bauelementstapel bereitzustellen. Als Isolationsmaterial zwischen der Rohrfeder und den Außenelektroden des Bauelementstapels ist auf dem Bauelementstapel außenumfangsseitig eine Schicht, z.B. aus Silikon, vorgesehen, welche zumindest die Außenelektroden bedeckt.

Aus der EP 1 835 553 A1 ist ein Verfahren zum Herstellen eines piezoelektrischen Aktuators bekannt, bei dem die Kontaktierungsstruktur auf eine subtraktiv oder additiv auf entsprechende Stapelumfangsbereiche aufgebrachte Isolationsschicht aufgebracht ist.

DE 199 13 271 A1 offenbart einen piezoelektrischen Aktor mit einer Vielzahl von Scheiben aus piezoelektrischem Material, die zu einem Stapel angeordnet sind und eine Vielzahl von flächigen Innenelektroden, die mit den Scheiben aus piezoelektrischem Material alternierend angeordnet sind. Weiter sind an der Außenseite des Stapel Außenelektroden angebracht, wobei die Innenelektroden alternierend mit jeweils einer der Außenelektroden über einen Kontaktbereich verbunden sind, wobei die Außenelektroden in Form einer Beschichtung aus einem elastischen elektrisch leitfähigen Polymermaterial aufgebracht sind.

In DE 10 2010 063 205 A1 ist ein piezoelektrischer Aktor mit einer Vielzahl von Schichten und einer Vielzahl von zwischen den Schichten angeordneten Elektrodenschichten beschrieben, wobei zumindest ein Teil der Elektrodenschichten an die Außenseite des Aktors herangeführt ist und an der Außenseite mit lokal ausgestalteten elektrischen Isolationsschichten überdeckt ist. Diese Isolationsschichten können auf einem Glas basieren.

US 2006/0067029 A1 offenbart eine Schichtstruktur aus piezoelektrischen Lagen mit Innenelektroden, wobei an einer Außenseite der Schichtstruktur eine Elektrodenschicht mit Metalloxiden, Metallnitriden, Metallfluoriden oder Metallsulfiden vorhanden ist, während auf einer anderen Oberflächenseite eine zweite Beschichtung mit Metalloxid, Metallnitrit, Metallfluorid oder Metallsulfid vorhanden ist.

In EP 1 107 325 A2 ist ein piezoelektrisches keramisches Element beschrieben, das eine Vielzahl von Innenelektroden und eine Vielzahl von piezoelektrischen Lagen alternativ über einander gestapelt aufweist. Weiter ist eine Abschlusselektrode offenbart, die an einer Kante des piezoelektrischen keramischen Elementes angeordnet ist und einen Leitpfad zu den Innenelektroden bildet.

Zusätzlich ist ein Film an einer Oberfläche des keramischen Elementes vorgesehen, der aus einem isolierenden Glasmaterial gefertigt ist.

EP 0 113 999 A1 offenbart einen Schichtstapel aus piezoelektrischen Material und Innenelektroden, die an gegenüberliegenden Seiten des Elementes aus dem Element hervorstehen. Zumindest jede zweite Elektrode ist durch eine Isolationsschicht eines anorganischen Materials, wie z.B. Glas oder Glaskeramik bedeckt. Das Glas bzw. die Glaskeramik wird durch einen elektrophoretischen Prozess hergestellt und wird dann auf das piezoelektrische Element aufgesintert.

Es ist Aufgabe der vorliegenden Erfindung, ein Verfahren zum Herstellen eines Bauelements anzugeben, welches hinsichtlich gesundheitsschädlicher Aspekte im Herstellungsablauf verbessert ist. Ferner ist es Aufgabe der Erfindung, ein gemäß dem Verfahren hergestelltes Bauelement anzugeben.

Diese Aufgaben werden durch ein Verfahren gemäß den Merkmalen des Anspruches 1 und ein als Stapel ausgebildetes Bauelement gemäß den Merkmalen des Anspruches 8 gelöst. Vorteilhafte Ausgestaltungen ergeben sich jeweils aus den abhängigen Ansprüchen.

Die Erfindung schafft ein Verfahren zum Herstellen eines elektronischen Bauelements als Stapel, das aus einer Mehrzahl von auf Anlegen eines elektrischen Feldes reagierenden Werkstoffschichten und einer Mehrzahl von ersten und zweiten Elektronenschichten gebildet ist, wobei jede Werkstoffschicht alternierend zwischen einer ersten und einer zweiten Elektrodenschichten angeordnet ist. Auf zumindest einen Stapelumfangsbereich werden zumindest eine erste und eine zweite Kontaktierungsstruktur aufgebracht, so dass durch die erste Kontaktierungsstruktur jede erste Elektrodenschicht und durch die zweite Kontaktierungsstruktur jede zweite Elektrodenschicht elektrisch kontaktiert sind. Zunächst wird ein Stapel erzeugt, bei dem die ersten Elektrodenschichten über den zumindest einen Stapelumfangsbereich hinausstehen und die zweiten Elektrodenschichten innerhalb der Werkstoffschichten beabstandet zu dem zumindest einen Stapelumfangsbereich zum Liegen kommen. Anschließend wird die erste Kontaktierungsstruktur direkt auf den zumindest einen Stapelumfangsbereich aufgebracht, wobei die aus dem zumindest einen Stapelumfangsbereich herausstehenden ersten Elektrodenschichten elektrisch leitend in die erste Kontaktierungsstruktur eingebettet werden. Sodann wird die zweite Kontaktierungsstruktur erzeugt wird, indem auf dem zumindest einen Stapelumfangsbereich die ersten und zweiten Elektrodenschichten freigelegt werden, weiter eine lösemittelfreie Isolationsstruktur durch ein additives Verfahren erzeugt wird, welche die ersten Elektrodenschichten elektrisch von dem zumindest einen Stapelumfangsbereich isoliert, und zuletzt elektrisch leitfähiges Material zur Ausbildung der zweiten Kontaktierungsstruktur auf den vorbereiteten Stapelumfangsbereich aufgebracht wird.

Der Vorteil des vorgeschlagenen Verfahrens besteht darin, dass bislang erforderliche Prozesse, welche gesundheitsschädliche Stoffe, wie z.B. Lösungsmittel, enthalten, entfallen können. Insbesondere kann auf das Aufbringen einer Passivierung aus Polyimid verzichtet werden. Dies ist eine große Erleichterung, da diese für die Funktionsfähigkeit und Dauerhaltbarkeit hohe Genauigkeit bezüglich Schichtdicke, Homogenität und Positionsgenauigkeit erfordern Ebenso kann auf das Aufbringen einer Leitkleberschicht mit ebenfalls für den Menschen schädlichen Stoffen verzichtet werden.

Der Schritt des Erzeugens des Stapels umfasst das Bereitstellen eines ungesinterten Stapels aus den abwechselnd angeordneten Werkstoffschichten und ersten und zweiten Elektrodenschichten, wobei die Werkstoffschichten, die ersten Elektrodenschichten, die mit der ersten Kontaktierungsstruktur zu verbinden sind, und die zweiten Elektrodenschichten, die mit der zweiten Kontaktierungsstruktur zu verbinden sind, ein unterschiedliches Schrumpfverhalten beim Sintern aufweisen.

Der Schritt des Erzeugens des Stapels umfasst ferner das Sintern des Stapels, wodurch die ersten Elektrodenschichten über den zumindest eine Stapelumfangsbereich hinausstehen und die zweiten Elektrodenschichten innerhalb der Werkstoffschichten beabstandet zu dem zumindest einen Stapelumfangsbereich zum Liegen kommen.

Die Materialien der ersten und zweiten Elektrodenschichten und der Werkstoffschichten werden derart gewählt, dass beim Sintern des Stapels die zweiten Elektrodenschichten stärker schrumpfen als die Werkstoffschichten und die Werkstoffschichten stärker schrumpfen als die ersten Elektrodenschichten.

Dieses Vorgehen ermöglicht das direkte Aufbringen der ersten Kontaktierungsstruktur, ohne dass zuvor eine Isolationsstruktur geschaffen werden müsste. Hierdurch entfallen Prozesse, bei denen für die Passivierung erforderliche Materialien in extremer Genauigkeit bezüglich Schichtdicke, Homogenität und Positionsgenauigkeit aufgebracht werden müssen.

Insbesondere kann das Aufbringen der ersten Kontaktierungsstruktur durch Einbrennen des Materials der ersten Kontaktierungsstruktur auf den zumindest einen Stapelumfangsbereich erfolgen. Diese Vorgehensweise wird beispielsweise bei nicht vollaktiven Stapeln angewandt und ist gut erprobt. Die Kontaktierung der zweiten Kontaktierungsstruktur kann z.B. durch Leitkleber erfolgen.

Das Freilegen der zweiten Elektrodenschichten auf dem zumindest einen Stapelumfangsbereich umfasst in einer zweckmäßigen Ausgestaltung das Schleifen des zumindest einen Stapelumfangsbereichs. Durch das Schleifen kann eine ebene Oberfläche des Stapelumfangsbereichs erzielt werden. Gleichzeitig ist eine sehr genaue Kontrolle möglich, wann die zweiten Elektrodenschichten erreicht sind.

Eine besonders einfache Fertigung ergibt sich dadurch, dass die erste und die zweite Kontaktierungsstruktur auf unterschiedlichen Stapelumfangsbereichen ausgebildet werden. Vorzugsweise liegen die zwei Stapelumfangsbereiche einander gegenüber und kommen parallel zueinander zum Liegen.

Das Erzeugen der Isolationsstruktur erfolgt gemäß einer zweckmäßigen Ausgestaltung durch elektrochemische Abscheidung, indem an die erste Kontaktierungsstruktur eine Spannung angelegt wird. Hierdurch kann eine gezielte Passivierung der bereits ankontaktierten Elektroden auf dem Bereich, auf dem die zweite Kontaktierungsstruktur erzeugt werden soll, erfolgen. Das Vorgehen basiert darauf, dass in einem elektrolytischen Bad mittels einer elektrischen Spannung, die zwischen der bereits am Stapel vorhandenen Elektrode und einer zweiten Elektrode in diesem elektrolytischen Bad angelegt wird, eine Abscheidung eines isolierenden Materials erfolgt. Dazu ist es erforderlich, das alle Elektroden des Stapels an der Oberfläche des noch zu kontaktierenden Stapelumfangsbereichs herausschauen.

Die Erfindung schlägt weiter ein als Stapel ausgebildetes elektronisches Bauelement vor. Dieses umfasst eine Mehrzahl von ersten und zweiten Elektrodenschichten und eine Mehrzahl von auf Anlegen eines elektrischen Feldes reagierenden Werkstoffschichten, wobei jede Werkstoffschicht alternierend zwischen einer ersten und einer zweiten Elektrodenschicht angeordnet ist. Auf zumindest einen Stapelumfangsbereich sind eine erste und eine zweite Kontaktierungsstruktur aufgebracht, so dass durch die erste Kontaktierungsstruktur jede erste Elektrodenschicht und durch die zweite Kontaktierungsstruktur jede zweite Elektrodenschicht elektrisch kontaktiert sind. Die erste Kontaktierungsstruktur ist direkt auf den zumindest einen Stapelumfangsbereich aufgebracht, wobei die aus dem zumindest einen Stapelumfangsbereich herausstehenden ersten Elektrodenschichten elektrisch leitend in die erste Kontaktierungsstruktur eingebettet sind. Die zweite Kontaktierungsstruktur ist auf eine lösemittelfreie Isolationsstruktur des zumindest einen Stapelumfangsbereich des Stapels aufgebracht und elektrisch mit den zweiten Elektrodenschichten verbunden.

Das vorgeschlagene Bauelement lässt sich auf umweltverträglichere Weise herstellen. Darüber hinaus weist es eine größere Dauerhaltbarkeit auf als solche vollaktive Bauelemente, welche in herkömmlicher Weise mit einer aus Polyimid bestehenden Passivierung hergestellt sind.

Die Herstellung eines erfindungsgemäßen Bauelements wird nachfolgend näher anhand eines Ausführungsbeispiels erläutert. Es zeigen:
- Fig. 1: einen Stapel aus alternierend angeordneten Werkstoffschichten und Elektrodenschichten vor dem Sintern in einer schematischen Querschnittsdarstellung,
- Fig. 2: den Stapel aus alternierend angeordneten Werkstoffschichten und Elektrodenschichten nach dem Sintern in einer schematischen Querschnittsdarstellung,
- Fig. 3: den Stapel nach dem Aufbringen einer ersten Kontaktierungsstruktur zur Kontaktierung erster Elektrodenschichten in einer schematischen Querschnittsdarstellung,
- Fig. 4: den Stapel nach dem Schleifen eines Stapelumfangsbereichs, auf dem eine zweite Kontaktierungsstruktur aufgebracht werden soll, in einer schematischen Querschnittsdarstellung,
- Fig. 5: den Stapel nach dem Erzeugen einer Isolationsstruktur auf dem Stapelumfangsbereich, auf dem die zweite Kontaktierungsstruktur aufgebracht werden soll, in einer schematischen Querschnittsdarstellung, und
- Fig. 6: den Stapel nach dem Aufbringen der zweiten Kontaktierungsstruktur zur Kontaktierung zweiter Elektrodenschichten in einer schematischen Querschnittsdarstellung.

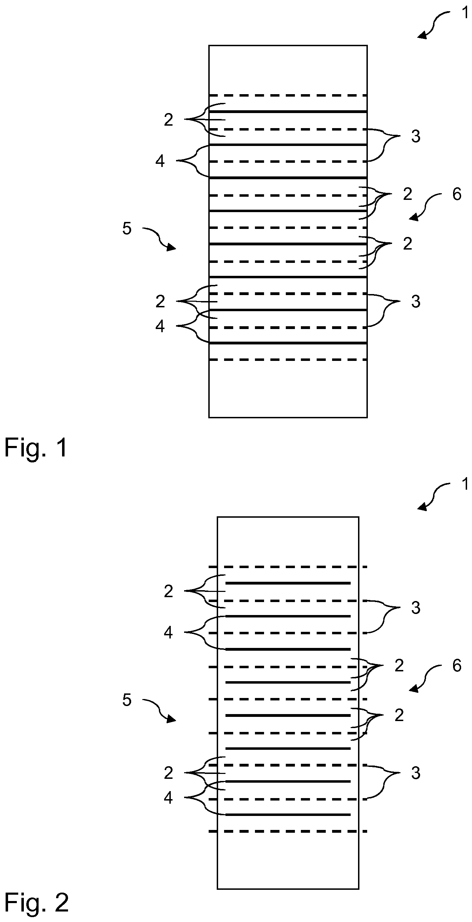

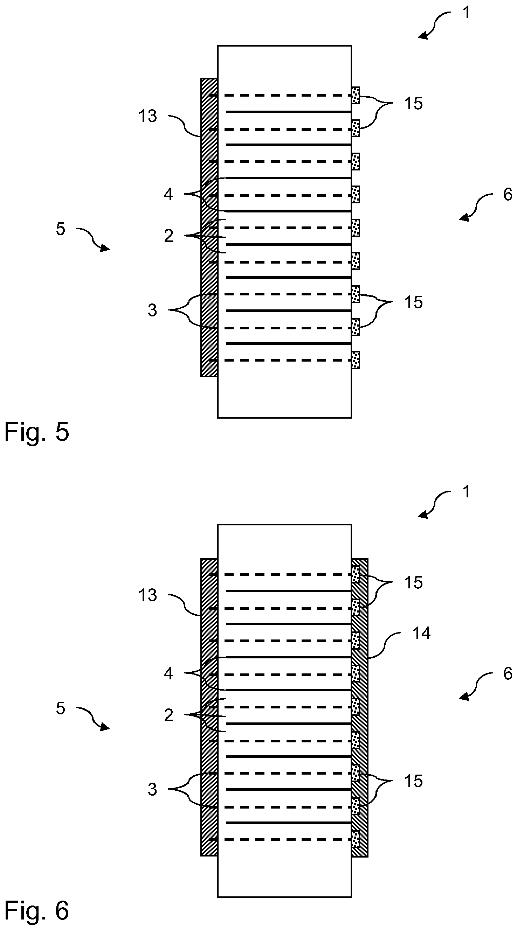

Die Figuren 1 bis 6 zeigen die zur Herstellung des in Fig. 6 gezeigten erfindungsgemäßen, als Stapel ausgebildeten Bauelements notwendigen Zwischenstufen.

Ausgangspunkt des Herstellungsprozesses ist ein als Stapel 1 ausgebildetes elektronisches Bauelement, wie dies in Fig. 1 in einer schematischen Schnittdarstellung gezeigt ist. Der Stapel 1 ist aus einer Mehrzahl von auf Anlegen eines elektrischen Feldes reagierenden Werkstoffschichten 2 und einer Mehrzahl von ersten Elektrodenschichten 3 (dargestellt als durchbrochene Linien) und zweiten Elektrodenschichten 4 (dargestellt als durchgezogenen Linien) gebildet. Jede der Werkstoffschichten 2 ist alternierend zwischen einer ersten Elektrodenschicht 3 und einer zweiten Elektrodenschicht 4 angeordnet. Die Elektrodenschichten 3, 4 sind, da diese als Keramik noch im Grünzustand vorliegen, beidseitig bis an die jeweiligen Ränder des Stapels 1 geführt. Die zu erzeugende Kontaktierung erfolgt beispielhaft auf gegenüberliegenden und geometrisch nicht zusammenhängenden Stapelumfangsbereichen 5, 6.

Für die Erzeugung einer Kontaktierungsstruktur 13 auf dem Stapelumfangsbereich 5 und einer Kontaktierungsstruktur 14 auf dem Stapelumfangsbereich 6 ist es erforderlich, dass jede zweite Elektrode über die Stapelumfangsbereiche 5 und/oder 6 hinausschaut und die anderen Elektroden innerhalb der Werkstoffschichten beabstandet zu den Stapelumfangsbereich 5 und 6 zum Liegen kommen. Im Ausführungsbeispiel ragen die ersten Elektrodenschichten 3 nach dem Sintern über die Stapelumfangsbereiche 5 und 6 hinaus, die Elektrodenschichten 4 liegen im Inneren des Stapels 1 (vgl. Fig. 2). Die Elektrodenschichten 4 können alternativ auch mit den Oberflächen der Stapelumfangsbereiche 5, 6 abschließen.

Um dies zu erzielen, ist die Materialbeschaffenheit der ersten und zweiten Elektrodenschichten 3, 4 unterschiedlich, so dass diese während des Sintern ein unterschiedliches Schrumpfverhalten aufweisen. Dies bedeutet, bereits während der Sinterung der grünen Keramik verhalten sich die Werkstoffschichten und die Elektrodenschichten bezüglich der Schrumpfung unterschiedlich.

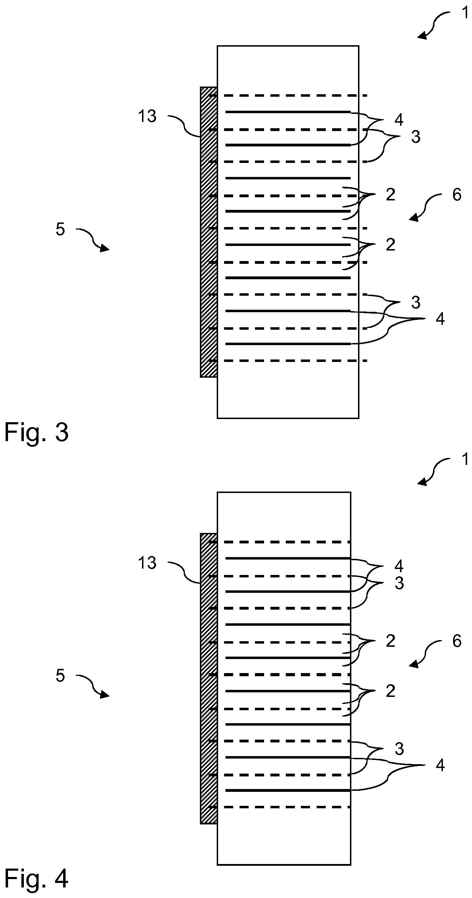

Im nächsten Schritt (vgl. Fig. 3) wird auf den Stapelumfangsbereich 5 eine erste Kontaktierungsstruktur 13 (sog. Außenkontaktierung) aufgebracht. Dies kann z.B. durch Einbrennen eines metallischen Materials erfolgen. Das Einbrennen, z.B. von Silberelektroden, ist dem Fachmann hinlänglich bekannt. Bei diesem Verfahren werden mehrere Schichten einer Silberpaste aufgetragen und eingebrannt. Der Sinn dieser mehreren Schichten besteht darin, dass die Haftung auf der Keramik nur mit Zusätzen in der Silberpaste möglich ist. Dieser Zusatz wird schichtweise reduziert, so dass die oberste Schicht keine Zusätze mehr enthält. Darauf wird dann schließlich die Weiterkontaktierung aufgelötet. Im Ergebnis ist die erste Kontaktierungsstruktur 13 mit jeweils jeder zweiten Elektrode, d.h. den ersten Elektrodenschichten 3, verbunden, so dass bei Anlegen einer Spannung an die Kontaktierungsstruktur alle Elektrodenschichten 3 das gleiche Potential aufweisen.

Um die anderen Elektroden, d.h. die zweiten Elektrodenschichten 4, mit einem anderen Potential zu verbinden, wird der gegenüberliegende Stapelumfangsbereich 6 des Stapels abgeschliffen. Das Abschleifen erfolgt derart, dass alle Elektrodenschichten 3, 4 bis an die Oberfläche des Stapelumfangsbereichs 6 grenzen. Diese Situation ist in Fig. 4 dargestellt. Das Schleifen weist den Vorteil auf, dass der Stapelumfangsbereich eine plane Oberfläche hat, bevor die zweite Kontaktierungsstruktur 14 erzeugt wird.

Durch Anlegen eines elektrischen Feldes an die bereits erzeugte erste Kontaktierungsstruktur 13 wird mit Hilfe einer elektrochemischen Abscheidung eine gezielte Passivierung der mit der ersten Kontaktierungsstruktur 13 elektrisch verbundenen ersten Elektrodenschichten 3 auf dem Stapelumfangsbereich 6 erreicht. Die Isolationsstreifen 15 erstrecken sich in Fig. 5 entsprechend dem Verlauf der ersten Elektrodenschichten 3 senkrecht in die Blattebene hinein.

In einem letzten Schritt wird auf den Stapelumfangsbereich 6 die zweite Kontaktierungsstruktur 14 aufgebracht. Hierdurch sind die zweiten Elektrodenschichten mit der Kontaktierungsstruktur 14 elektrisch verbunden. Dies ist in Fig.6 gezeigt. Das Aufbringen der zweiten Kontaktierungsstruktur kann durch z.B. durch Leitkleber erfolgen.

Der so hergestellte Stapel 1 dient beispielsweise als Piezoaktor für einen Piezoinjektor für einen Verbrennungsmotor.

Das beschriebene Herstellungsverfahren ermöglicht einen Verzicht auf gesundheitsschädliche Polyimide. Ein weiterer Vorteil besteht darin, dass durchgängig Prozesse eingesetzt werden können, welche bezüglich Schichtdicken, Homogenität und Positionsgenauigkeit keine hohen Anforderungen stellen. Hierdurch vereinfacht sich das Herstellungsverfahren.

## Patentansprüche

1. Verfahren zum Herstellen eines elektronischen Bauelements als Stapel (1), das aus einer Mehrzahl von auf Anlegen eines elektrischen Feldes reagierenden Werkstoffschichten (2) und einer Mehrzahl von ersten und zweiten Elektrodenschichten (3, 4) gebildet ist, wobei jede Werkstoffschicht (2) alternierend zwischen einer ersten und einer zweiten Elektrodenschicht (3, 4) angeordnet ist, bei dem
- auf zumindest einen Stapelumfangsbereich (5, 6) zumindest eine erste und eine zweite Kontaktierungsstruktur (13, 14) aufgebracht werden, so dass durch die erste Kontaktierungsstruktur (13) jede erste Elektrodenschicht (3) und durch die zweite Kontaktierungsstruktur (14) jede zweite Elektrodenschicht (4) elektrisch kontaktiert sind;
wobei
a) ein Stapel (1) erzeugt wird, bei dem die ersten Elektrodenschichten (3) über den zumindest einen Stapelumfangsbereich (5, 6) hinausstehen und die zweiten Elektrodenschichten (4) innerhalb der Werkstoffschichten (2) beabstandet zu dem zumindest einen Stapelumfangsbereich (5, 6) zum Liegen kommen;
b) die erste Kontaktierungsstruktur (13) direkt auf den zumindest einen Stapelumfangsbereich (5, 6) aufgebracht wird, wobei die aus dem zumindest einen Stapelumfangsbereich (5, 6) herausstehenden ersten Elektrodenschichten (3) elektrisch leitend in die erste Kontaktierungsstruktur (13) eingebettet werden;
c) die zweite Kontaktierungsstruktur (14) erzeugt wird, indem
- auf dem zumindest einen Stapelumfangsbereich (5, 6) die ersten und zweiten Elektrodenschichten (3, 4) freigelegt werden;
- eine lösemittelfreie Isolationsstruktur (15) durch ein additives Verfahren erzeugt wird, welche die ersten Elektrodenschichten (3) elektrisch von dem zumindest einen Stapelumfangsbereich (5, 6) isoliert, und
- elektrisch leitfähiges Material zur Ausbildung der zweiten Kontaktierungsstruktur (14) auf den vorbereiteten Stapelumfangsbereich (5, 6) aufgebracht wird,
**dadurch gekennzeichnet, dass** die Materialien der ersten und zweiten Elektrodenschichten und der Werkstoffschichten (2) derart gewählt werden, dass beim Sintern des Stapels (1) die zweiten Elektrodenschichten (4) stärker schrumpfen als die Werkstoffschichten (2) und die Werkstoffschichten (2) stärker schrumpfen als die ersten Elektrodenschichten (3).

2. Verfahren nach Anspruch 1, **dadurch gekennzeichnet, dass** Schritt a) das Bereitstellen eines ungesinterten Stapels (1) aus den abwechselnd angeordneten Werkstoffschichten (2) und ersten und zweiten Elektrodenschichten (3, 4) umfasst, wobei die Werkstoffschichten (2), die ersten Elektrodenschichten (3), die mit der ersten Kontaktierungsstruktur (13) zu verbinden sind, und die zweiten Elektrodenschichten (4), die mit der zweiten Kontaktierungsstruktur (14) zu verbinden sind, ein unterschiedliches Schrumpfverhalten beim Sintern aufweisen.

3. Verfahren nach Anspruch 1 oder 2, **dadurch gekennzeichnet, dass** Schritt a) das Sintern des Stapels (1) umfasst, wodurch die ersten Elektrodenschichten (3) über den zumindest eine Stapelumfangsbereich (5, 6) hinausstehen und die zweiten Elektrodenschichten (4) innerhalb der Werkstoffschichten (2) beabstandet zu dem zumindest einen Stapelumfangsbereich (5, 6) zum Liegen kommen.

4. Verfahren nach einem der vorhergehenden Ansprüche, **dadurch gekennzeichnet, dass** Schritt b) das Einbrennen des Materials der ersten Kontaktierungsstruktur (13) auf den zumindest einen Stapelumfangsbereich umfasst.

5. Verfahren nach einem der vorhergehenden Ansprüche, **dadurch gekennzeichnet, dass** das Freilegen der zweiten Elektrodenschichten (4) auf dem zumindest einen Stapelumfangsbereich (5, 6) in Schritt c) das Schleifen des zumindest einen Stapelumfangsbereichs (5, 6) umfasst.

6. Verfahren nach einem der vorhergehenden Ansprüche, **dadurch gekennzeichnet, dass** die erste und die zweite Kontaktierungsstruktur auf unterschiedlichen Stapelumfangsbereichen (5, 6) ausgebildet werden.

7. Verfahren nach einem der vorhergehenden Ansprüche, **dadurch gekennzeichnet, dass** das Erzeugen der Isolationsstruktur (15) durch elektrochemische Abscheidung erfolgt, indem an die erste Kontaktierungsstruktur (13) eine Spannung angelegt wird.

8. Als Stapel (1) ausgebildetes elektronisches Bauelement, umfassend:
- eine Mehrzahl von ersten und zweiten Elektrodenschichten (3, 4);
- eine Mehrzahl von auf Anlegen eines elektrischen Feldes reagierenden Werkstoffschichten (2), wobei jede Werkstoffschicht (2) alternierend zwischen einer ersten und einer zweiten Elektrodenschicht (3, 4) angeordnet ist;
- einer ersten und einer zweiten Kontaktierungsstruktur (13, 14), die auf zumindest einen Stapelumfangsbereich (5, 6) aufgebracht sind, so dass durch die erste Kontaktierungsstruktur (13) jede erste Elektrodenschicht (3) und durch die zweite Kontaktierungsstruktur (14) jede zweite Elektrodenschicht (4) elektrisch kontaktiert sind;
wobei
- die erste Kontaktierungsstruktur (13) direkt auf den zumindest einen Stapelumfangsbereich (5, 6) aufgebracht ist, wobei die aus dem zumindest einen Stapelumfangsbereich (5, 6) herausstehenden ersten Elektrodenschichten (3) elektrisch leitend in die erste Kontaktierungsstruktur (13) eingebettet sind;
- die zweite Kontaktierungsstruktur (14) auf eine lösemittelfreie Isolationsstruktur (15) des zumindest einen Stapelumfangsbereich (5, 6) des Stapels (1) aufgebracht und elektrisch mit den zweiten Elektrodenschichten (4) verbunden ist,
**dadurch gekennzeichnet, dass** die Materialien der ersten und zweiten Elektrodenschichten und der Werkstoffschichten (2) derart gewählt sind, dass beim Sintern des Stapels (1) die zweiten Elektrodenschichten (4) stärker schrumpfen als die Werkstoffschichten (2) und die Werkstoffschichten (2) stärker schrumpfen als die ersten Elektrodenschichten (3).

## Claims

1. Method for producing an electronic structural element as a stack (1), which is formed from a plurality of material layers (2) reacting to the application of an electrical field and a plurality of first and second electrode layers (3, 4), each material layer (2) being arranged alternately between a first and a second electrode layer (3, 4), in which
- at least one first and one second contacting structure (13, 14) are applied to at least one stack circumferential region (5, 6), so that every first electrode layer (3) is contacted electrically by the first contacting structure (13) and every second electrode layer (4) is contacted electrically by the second contacting structure (14);
wherein
a) a stack (1) is generated, in which the first electrode layers (3) project above the at least one stack circumferential region (5, 6), and the second electrode layers (4) come to lie within the material layers (2) at a distance from the at least one stack circumferential region (5, 6);
b) the first contacting structure (13) is applied directly to the at least one stack circumferential region (5, 6), the first electrode layers (3) which project from the at least one stack circumferential region (5, 6) being embedded in an electrically conductive manner into the first contacting structure (13) ;
c) the second contacting structure (14) is generated in that
- the first and second electrode layers (3, 4) are exposed on the at least one stack circumferential region (5, 6);
- a solvent-free insulating structure (15) is generated by means of an additive method and insulates the first electrode layers (3) electrically from the at least one stack circumferential region (5, 6), and
- electrically conductive material is applied to the prepared stack circumferential region (5, 6) in order to form the second contacting structure (14),
**characterized in that** the materials of the first and second electrode layers and the material layers (2) are selected in such a way that, during the sintering of the stack (1), the second electrode layers (4) shrink to a greater extent than the material layers (2) and the material layers (2) shrink to a greater extent than the first electrode layers (3).

2. Method according to Claim 1, **characterized in that** step a) comprises the provision of an unsintered stack (1) composed of the alternately arranged material layers (2) and first and second electrode layers (3, 4), the material layers (2), the first electrode layers (3), which are to be connected to the first contacting structure (13), and the second electrode layers (4), which are to be connected to the second contacting structure (14), having a different shrinkage behavior during sintering.

3. Method according to Claim 1 or 2, **characterized in that** step a) comprises the sintering of the stack (1), with the result that the first electrode layers (3) project above the at least one stack circumferential region (5, 6), and the second electrode layers (4) come to lie within the material layers (2) at a distance from the at least one stack circumferential region (5, 6).

4. Method according to one of the preceding claims, **characterized in that** step b) comprises the burning of the material of the first contacting structure (13) onto the at least one stack circumferential region.

5. Method according to one of the preceding claims, **characterized in that** the exposure of the second electrode layers (4) on the at least one stack circumferential region (5, 6) in step c) comprises the grinding of the at least one stack circumferential region (5, 6).

6. Method according to one of the preceding claims, **characterized in that** the first and the second contacting structure are formed on different stack circumferential regions (5, 6).

7. Method according to one of the preceding claims, **characterized in that** the generation of the insulating structure (15) takes place by electrochemical deposition in that voltage is applied to the first contacting structure (13).

8. Electronic structural element formed as a stack (1), comprising:
- a plurality of first and second electrode layers (3, 4) ;
- a plurality of material layers (2) reacting to the application of an electrical field, each material layer (2) being arranged alternately between a first and a second electrode layer (3, 4);
- a first and a second contacting structure (13, 14) which are applied to at least one stack circumferential region (5, 6), so that every first electrode layer (3) is contacted electrically by the first contacting structure (13) and every second electrode layer (4) is contacted electrically by the second contacting structure (14);
wherein
- the first contacting structure (13) is applied directly to the at least one stack circumferential region (5, 6), the first electrode layers (3) which project from the at least one stack circumferential region (5, 6) being embedded in an electrically conductive manner into the first contacting structure (13);
- the second contacting structure (14) is applied to a solvent-free insulating structure (15) of the at least one stack circumferential region (5, 6) of the stack (1) and is connected electrically to the second electrode layers (4), **characterized in that** the materials of the first and second electrode layers and the material layers (2) are selected in such a way that, during the sintering of the stack (1), the second electrode layers (4) shrink to a greater extent than the material layers (2) and the material layers (2) shrink to a greater extent than the first electrode layers (3).

## Revendications

1. Procédé de fabrication d'un composant électronique sous la forme d'un empilement (1), lequel est formé par une pluralité de couches de matière (2) qui réagissent lors de l'application d'un champ électrique et par une pluralité de premières et de deuxièmes couches d'électrode (3, 4), chaque couche de matière (2) étant disposée en alternance entre une première et une deuxième couche d'électrode (3, 4), procédé selon lequel
- au moins une première et une deuxième structure de mise en contact (13, 14) sont appliquées sur au moins une zone périphérique d'empilement (5, 6), de sorte que chaque première couche d'électrode (3) est mise en contact électriquement par la première structure de mise en contact (13) et chaque deuxième couche d'électrode (4) par la deuxième structure de mise en contact (14) ;
a) un empilement (1) étant produit, dans lequel les premières couches d'électrode (3) dépassent au-delà de l'au moins une zone périphérique d'empilement (5, 6) et les deuxièmes couches d'électrode (4) se retrouvent à l'intérieur des couches de matière (2) espacées de l'au moins une zone périphérique d'empilement (5, 6) ;
b) la première structure de mise en contact (13) est appliquée directement sur l'au moins une zone périphérique d'empilement (5, 6), les premières couches d'électrode (3) qui dépassent de l'au moins une zone périphérique d'empilement (5, 6) étant enrobées de manière électriquement conductrice dans la première structure de mise en contact (13) ;
c) la deuxième structure de mise en contact (14) est produite en
- libérant les premières et deuxièmes couches d'électrode (3, 4) sur l'au moins une zone périphérique d'empilement (5, 6) ;
- produisant une structure d'isolation (15) exempte de solvant par un procédé additif, laquelle isole électriquement les premières couches d'électrode (3) de l'au moins une zone périphérique d'empilement (5, 6), et
- appliquant un matériau électriquement conducteur sur la zone périphérique d'empilement (5, 6) préparée en vue de former la deuxième structure de mise en contact (14),
**caractérisé en ce que** les matériaux des premières et deuxièmes couches d'électrode et des couches de matière (2) sont choisis de telle sorte que lors du frittage de l'empilement (1), les deuxièmes couches d'électrode (4) se rétractent plus fortement que les couches de matière (2) et les couches de matière (2) se rétractent plus fortement que les premières couches d'électrode (3) .

2. Procédé selon la revendication 1, **caractérisé en ce que** l'étape a) comprend la fourniture d'un empilement (1) non fritté constitué des couches de matière (2) et des premières et deuxièmes couches d'électrode (3, 4) disposées en alternance, les couches de matière (2), les premières couches d'électrode (3) qui sont à relier avec la première structure de mise en contact (13) et les deuxièmes couches d'électrode (4) qui sont à relier avec la deuxième structure de mise en contact (14) possédant un comportement de rétraction différent lors du frittage.

3. Procédé selon la revendication 1 ou 2, **caractérisé en ce que** l'étape a) comprend le frittage de l'empilement (1), ce par quoi les premières couches d'électrode (3) dépassent au-delà de l'au moins une zone périphérique d'empilement (5, 6) et les deuxièmes couches d'électrode (4) se retrouvent à l'intérieur des couches de matière (2) espacées de l'au moins une zone périphérique d'empilement (5, 6).

4. Procédé selon l'une des revendications précédentes, **caractérisé en ce que** l'étape b) comprend la cuisson du matériau de la première structure de mise en contact (13) sur l'au moins une zone périphérique d'empilement.

5. Procédé selon l'une des revendications précédentes, **caractérisé en ce que** la libération des deuxièmes couches d'électrode (4) sur l'au moins une zone périphérique d'empilement (5, 6) à l'étape c) comprend la rectification de l'au moins une zone périphérique d'empilement (5, 6).

6. Procédé selon l'une des revendications précédentes, **caractérisé en ce que** la première et la deuxième structure de mise en contact sont formées sur des zones périphériques d'empilement (5, 6) différentes.

7. Procédé selon l'une des revendications précédentes, **caractérisé en ce que** la production de la structure d'isolation (15) est effectuée par déposition électrochimique en appliquant une tension à la première structure de mise en contact (13).

8. Composant électronique réalisé sous la forme d'un empilement (1), comprenant :
- une pluralité de premières et de deuxièmes couches d'électrode (3, 4) ;
- une pluralité de couches de matière (2) qui réagissent lors de l'application d'un champ électrique, chaque couche de matière (2) étant disposée en alternance entre une première et une deuxième couche d'électrode (3, 4) ;
- une première et une deuxième structure de mise en contact (13, 14) qui sont appliquées sur au moins une zone périphérique d'empilement (5, 6), de sorte que chaque première couche d'électrode (3) est mise en contact électriquement par la première structure de mise en contact (13) et chaque deuxième couche d'électrode (4) par la deuxième structure de mise en contact (14) ;
- la première structure de mise en contact (13) étant appliquée directement sur l'au moins une zone périphérique d'empilement (5, 6), les premières couches d'électrode (3) qui dépassent de l'au moins une zone périphérique d'empilement (5, 6) étant enrobées de manière électriquement conductrice dans la première structure de mise en contact (13) ;
- la deuxième structure de mise en contact (14) étant appliquée sur une structure d'isolation (15) exempte de solvant de l'au moins une zone périphérique d'empilement (5, 6) de l'empilement (1) et étant reliée électriquement aux deuxièmes couches d'électrode (4),
**caractérisé en ce que** les matériaux des premières et deuxièmes couches d'électrode et des couches de matière (2) sont choisis de telle sorte que lors du frittage de l'empilement (1), les deuxièmes couches d'électrode (4) se rétractent plus fortement que les couches de matière (2) et les couches de matière (2) se rétractent plus fortement que les premières couches d'électrode (3) .
